**Europäisches Patentamt**

**European Patent Office**

**Office européen des brevets**

(19)

(11) Veröffentlichungsnummer: **0 322 585 B1**

# EUROPÄISCHE PATENTSCHRIFT

(12)

(45) Veröffentlichungstag der Patentschrift: **15.09.93**

(51) Int. Cl.5: **G03F 7/027**

(21) Anmeldenummer: **88119972.3**

(22) Anmeldetag: **30.11.88**

(54) **Verbesserte photopolymerisierbare Aufzeichnungsmaterialien.**

(30) Priorität: **24.12.87 DE 3744243**

(43) Veröffentlichungstag der Anmeldung:
**05.07.89 Patentblatt 89/27**

(45) Bekanntmachung des Hinweises auf die
Patenterteilung:
**15.09.93 Patentblatt 93/37**

(84) Benannte Vertragsstaaten:
**BE CH ES FR GB IT LI NL SE**

(56) Entgegenhaltungen:
**EP-A- 0 219 795**
**EP-A- 0 263 301**
**US-A- 4 320 188**

(73) Patentinhaber: **DU PONT DE NEMOURS**
**(DEUTSCHLAND) GMBH**
**Du Pont Strasse 1**
**D-61352 Bad Homburg(DE)**

(84) Benannte Vertragsstaaten:
**BE CH ES LI NL SE**

(73) Patentinhaber: **E.I. DU PONT DE NEMOURS**
**AND COMPANY**
**1007 Market Street**
**Wilmington Delaware 19898(US)**

(84) Benannte Vertragsstaaten:
**FR GB IT**

(72) Erfinder: **Schober, Manfred, Dr.**
**Hans-Steinhäuser-Strasse 6**
**6050 Offenbach(DE)**
Erfinder: **Schröder, Hans Leander**
**Königsberger Strasse 17**
**D-6107 Reinheim 1(DE)**

(74) Vertreter: **Pistor, Wolfgang**
**Du Pont de Nemours (Deutschland) GmbH**
**Patentabteilung Dornhofstrasse 10**
**D-63263 Neu-Isenburg (DE)**

**Beschreibung**

Die Erfindung betrifft eine lichtempfindliche Zusammensetzung für photopolymerisierbare Aufzeichnungsmaterialien enthaltend thermoplastisch, elastomere Blockcopolymerisate als Bindemittel, additionspolymerisierbare endständig ethylenisch ungesättigte Verbindungen und einen Photoinitiator oder ein Photoinitiatorsystem, wobei als additionspolymerisierbare Verbindungen bestimmte Mischungen aus Verbindungen mit nur einer Acrylat- bzw. Methacrylatgruppe und solchen mit mehreren der genannten Gruppen eingesetzt werden.

Es ist bekannt, für die Herstellung von Druckformen für den Flexodruck photopolymerisierbare Aufzeichnungsmaterialien zu verwenden, bei denen die Druckoberfläche durch bildmäßiges Belichten einer lichtempfindlichen Schicht und anschließendes Entfernen der unbelichteten Schichtteile erzeugt wird. Beispiele hierfür finden sich in den folgenden Patent- bzw. Offenlegunggschriften: US 2,948,611, US 3,024,180, US 3,798,035, US 3,951,657, DE 21 38 582, DE 22 15 090, DE 22 23 808 und DE 23 64 873.

Als Bindemittel in der lichtempfindlichen Schicht eignen sich besonders thermoplastisch, elastomere Blockcopolymere, z.B. solche vom A-B-A-Typ, die einen elastomeren Block, z.B. Polybutadien oder Polyisopren, zwischen zwei thermoplastischen Blöcken, z.B. Polystyrol, besitzen. Solche Blockcopolymere weisen wesentliche Vorteile gegenüber anderen polymeren Bindemitteln auf. So sind sie kommerziell erhältlich, preiswert, ohne Schwierigkeiten extrudierbar, zeigen eine gute Lösungsmittelbeständigkeit und kein kaltes Fließen. Flexographische Druckplatten bzw. -formen mit den genannten thermoplastisch, elastomeren Blockcopolymeren sind beispielsweise in DE-PS 22 15 090, DE-OS 22 23 808, DE-PS 28 15 678 und DE-PS 26 10 206 beschrieben.

Häufig entsprechen jedoch so hergestellte Druckformen nicht den in der Praxis im Flexodruck gestellten Anforderungen. Sie besitzen eine zu geringe Flexibilität und Elastizität, so daß beim Bedrucken unregelmäßiger Materialien durch ungenügende Anpassung an die Druckoberfläche oft unerwünschte Druckunterschiede auftreten.

Ein weiterer Nachteil der bekannten photopolymeren Druckformen ist ein oft auftretendes Ablösen der auf einem Druckzylinder montierten Druckformen. Dies ist in höchstem Maße unerwünscht, da hiermit ein Maschinen- und Produktionsstillstand verbunden ist. Dieses unerwünschte Ablösen der Druckformen vom Druckzylinder wird hauptsächlich durch die ungenügende Flexibilität bzw. durch die zu große Steifigkeit und Rückstellkraft der Druckformen verursacht.

Besonders bei langen Druckläufen tritt dieses Problem verstärkt auf, und speziell bei Druckzylindern mit kleinen Radien ist das Ablösen der Druckformen zu beobachten. Die Ecken der Druckformen sind hierbei vor allem gefährdet. Sie lösen sich schon nach kurzen Druckzeiten ab und machen somit ein Weiterdrucken unmöglich. Begünstigt wird das Ablösen der Druckformen durch Eindringen der Druckfarbenlösungsmittel in den Spalt zwischen den Kanten der um den Druckzylinder gewickelten Druckformen.

Verschiedene Vorschläge zur Herstellung photopolymerer Druckformen mit verbesserter Flexibilität und Elastizität sind bekannt. So wird die Verwendung von Blockcopolymeren auf der Basis reiner Elastomere als Bindemittel in photopolymerisierbaren Druckplatten vorgeschlagen (z.B. US 4,320,188 und US 4,430,417) oder der alleinige Einsatz von Polybutadien als Bindemittel (z.B. EP 00 76 588 und US 4,517,278).

Beide Verfahren weisen aber erhebliche Nachteile auf. Beim Einsatz reiner elastomerer Bindemittel werden durch die hohe Schmelzviskosität der elastomeren Blockcopolymere verfahrenstechnische Probleme hervorgerufen, wie z.B. eine schlechte Extrudierbarkeit der photopolymerisierbaren Materialien. Der Einsatz von Polybutadien als Bindemittel führt zu Druckformen mit einer schlechten Auswaschqualität aufgrund des ungünstigen Löslichkeitsverhalten des Polybutadien in den üblichen Entwicklungslösungen. Des weiteren neigen diese Bindemittel zum kalten Fließen, was zu einer geringen Lagerstabilität und einer ungenügenden Festigkeit der druckenden Oberfläche der Druckplatten bzw. - formen führt.

Ein anderes Verfahren, die Flexibilität und die Elastizität von Druckformen auf der Basis von photopolymerisierbaren Aufzeichnungsmaterialien zu verbessern, ist der Einsatz von Mehrschichtenplatten, in denen elastische Zwischen- oder Unterschichten zur Verbesserung der Biegsamkeit der Photopolymerschicht vorliegen (z.B. US 4,162,919, US 4,264,705, US 4,248,960, US 4,266,007).

Nachteilig ist hierbei, daß durch die zusätzlichen Schichten das Herstellungsverfahren der Druckplatten aufwendiger, fehleranfälliger und damit kostenintensiver wird. Außerdem sind in manchen Fällen zusätzlich Kleber oder spezielle Haftschichten zwischen den verschiedenen Schichten notwendig. Des weiteren ist ein Ablösen der einzelnen Schichten voneinander möglich und die Planarität der Druckplatten bzw. - formen ist nicht immer gegeben.

Es war somit keine Möglichkeit bekannt, die Flexibilität und Elastizität von Druckformen zu verbessern, ohne gleichzeitig andere wichtige Eigenschaften oder Vorteile der photopolymerisierbaren Aufzeichnungsmaterialien zu verschlechtern.

2

Der vorliegenden Erfindung lag daher die Aufgabe zugrunde, photopolymerisierbare Aufzeichnungsmaterialien mit lichtempfindlichen Zusammensetzungen auf der Basis von thermoplastisch, elastomeren Blockcopolymeren für die Herstellung von Druckformen zur Verfügung zu stellen, die eine verbesserte Flexibilität und geringere Rückstellkräfte aufweisen. Mit diesen Materialien sollte eine gute Haftsicherheit auf den Druckzylindern, besonders auf solchen mit kleinem Umfang, während des Druckvorganges gewährleistet werden. Gleichzeitig sollten andere Eigenschaften der photopolymerisierbaren Aufzeichnungsmaterialien nicht negativ beeinflußt werden, insbesondere eine Verringerung der Photoempfindlichkeit sollte vermieden werden. Auch die Härte der Druckformen sollte nicht wesentlich verringert werden, sie sollten eine Shore A Härte im Bereich von 35 - 55 besitzen.

Die Aufgabe wurde überraschenderweise gelöst durch eine lichtempfindliche Zusammensetzung für photopolymerisierbare Aufzeichnungsmaterialien, enthaltend mindestens ein thermoplastisch, elastomeres Blockcopolymerisat als Bindemittel, mindestens zwei additionspolymerisierbare, endständig ethylenisch ungesättigte Verbindungen und ein Photoinitiator oder ein Photoinitiatorsystem.

Die Erfindung ist dadurch gekennzeichnet, daß mindestens eine der additionspolymerisierbaren Verbindungen eine Verbindung mit nur einer Acrylat- bzw. Methacrylatgruppe ist und für ihre Homopolymere die Löslichkeitsparameter zwischen 7,6 und 9,6 und die Glasübergangstemperaturen unter 0° C liegen und mindestens eine der additionspolymerisierbaren Verbindungen eine Verbindung mit mehreren Acrylat- bzw. Methacrylatgruppen ist und für ihre Homopolymere die Löslichkeitsparameter zwischen 9,6 und 12 liegen und die Verbindungen mit nur einer und die Verbindungen mit mehreren Acrylat- bzw. Methacrylatgruppen in einem Verhältnis von > 3:1 bis 10:1 vorliegen.

Monomermischungen, die sowohl additionspolymerisierbare Verbindungen mit einer ethylenisch ungesättigten Gruppe als auch solche mit mehreren ethylenisch ungesättigten Gruppen enthalten, werden schon im Zusammenhang mit anderen photopolymerisierbaren Aufzeichnungsmaterialien erwähnt (US 4,517,278, US 4,162,919, US 4,266,007 und DE-OS 27 20 560). Hierbei handelt es sich aber um andere Bindemittel bzw. Mischungsverhältnisse. In der DE-OS 27 20 560 wird sogar ausdrücklich darauf hingewiesen, daß der Gehalt an Monomeren mit einer ethylenisch ungesättigten Gruppe nicht über 50% der Gesamtmonomerkonzentration, bevorzugt sogar unter 30%, liegen sollte. Die erfindungsgemäße, lichtempfindliche Zusammensetzung muß dagegen die Monomere mit nur einer ethylenisch ungesättigten Gruppe im mehr als drei- bis zehnfachen Überschuß zu den Monomeren mit mehreren ethylenisch ungesättigten Gruppen besitzen.

Ferner werden in den genannten Schriften als Bindemittel rein elastomere Blockcopolymere oder Polybutadiene verwendet, die aber die schon genannten schwerwiegenden Nachteile aufweisen, oder es werden Mehrschichtenplatten verwendet.

Die erfindungsgemäße, lichtempfindliche Zusammensetzung enthält jedoch als wesentlichen Bestandteil thermoplastisch, elastomere Blockcopolymere als Bindemittel, die die eingangs schon erwähnten wesentlichen Vorteile gegenüber anderen Polymeren besitzen. Bevorzugt werden z.B. lineare und radiale Blockcopolymere mit Polystyrol-Endblöcken, die auch ölverstreckt sein können.

Insbesondere Polystyrol-Polybutadien-Polystyrol oder Polystyrol-Polyisopren-Polystyrol-Blockcopolymere sind als Bindemittel in dem erfindungsgemäßen Aufzeichnungsmaterial geeignet. Das mittlere Molekulargewicht der Blockcopolymere sollte zwischen 80 000 und 300 000 liegen, bevorzugt zwischen 100 000 und 250 000. Ein Anteil an Polystyrol von 10 - 40 % ist vorteilhaft, vor allem ein Gehalt von 15 - 30 %.

Additionspolymerisierbare Verbindungen im Sinne der Erfindung sind solche, die eine selektive Block/Monomer-Verträglichkeit aufweisen. Dies bedeutet, daß in der lichtempfindlichen Zusammensetzung einerseits Monomere vorhanden sein müssen, die sowohl mit dem Elastomer- als auch mit dem Thermoplastblock des thermoplastisch-elastomeren, blockcopolymeren Bindemittels verträglich sind, zum anderen aber auch solche, die nur mit dem thermoplastischen Block des genannten Blockcopolymerisats verträglich sind.

Als Kriterium für diese Eigenschaften werden die Hildebrand schen Löslichkeitsparameter (vgl. z.B. Polymer Handbook, 2. Auflage, 1975, S. IV-337), herangezogen. Als erfindungsgemäße, additionspolymerisierbare Verbindungen, die die erste der oben genannten Anforderungen der selektiven Verträglichkeit sowohl mit dem Elastomer- als auch mit dem Thermoplastblock des Bindemittels erfüllen, sind solche Monomere mit nur einer Acrylat- bzw. Methacrylatgruppe geeignet, deren Homopolymere Löslichkeitsparameter zwischen 7,6 und 9,6 (angegeben in $(cal/cm^3)^{1/2}$), und Glasübergangstemperaturen unter 0° c, bevorzugt - 150 bis 0° C, besitzen. Insbesondere Ester offenkettiger, gegebenenfalls substituierter, aliphatischer Monoalkohole und/oder Monohydroxyether mit 2 bis 15 Kohlenstoffatomen in der Hauptkette werden eingesetzt.

Erfindungsgemäße, additionspolymerisierbare Verbindungen mit einer selektiven Verträglichkeit nur mit dem thermoplastische Block des Bindemittels sind solche Monomere mit mehreren Acrylat- bzw. Methacrylatgruppen, deren Homopolymere Löslichkeitsparameter zwischen 9.6 und 12 aufweisen. Insbesondere Ester aliphatischer, gegebenenfalls substituierter, Polyole und/oder Polyhydroxyether mit 2 bis 12 Kohlenstoffatomen in der Hauptkette sind geeignet. Als Beispiele für die erfindungsgemäßen, additionspolymerisierbaren Verbindungen seien genannt: Butylacrylat, Octylacrylat, Isodecylacrylat, Tetradecylacrylat, Isodecylmethacrylat, 2-Hexyloxyethylacrylat, 1,4-Butandioaldiacrylat, 1,6-Hexandiaoldiacrylat, 1,6-Hexandioldimethylacrylat, 1, 12-Dodecandioaldimethacrylat, Trimethylolpropantriacrylat und Dipentaerythritolmonohydroxypentaacrylat.

Durch das Verhältnis von Monomeren mit nur einer Acrylat- bzw. Methacrylatgruppe (M1) zu Monomeren mit mehreren der genannten Gruppen (M2) lassen sich selektiv die Eigenschaften des photopolymerisierbaren Aufzeichnungsmaterials im Sinne der gestellten Aufgabe (Erhöhung der Flexibilität ohne Verschlechterung anderer Eigenschaften der Druckplatte bzw. - formen, wie die Photoempfindlichkeit und die Härte) beeinflussen. Geeignet im Sinne der Erfindung ist ein Verhältnis von M1 zu M2 im Bereich von > 3:1 bis 10:1, bevorzugt bis 8:1. Hierbei können z.B. Mischungen von Verbindungen mit nur einer und solchen mit mehreren Acrylgruppen, von Verbindungen mit nur einer oder solchen mit mehreren Methacrylatgruppen oder von Verbindungen mit nur einer Methacrylat- und solchen mit mehreren Acrylatgruppen verwendet werden.

Desweiteren enthält die lichtempfindliche Zusammensetzung einen Photoinitiator oder ein Photoinitiatorsystem, z.B. $\alpha$-Methylbenzoin, Benzoinacetat, Benzophenon, Benzil-dimethylketal, Ethylanthrachinon/ 4,4'-Bis-(dimethylamino)benzophenon.

Ferner kannt die lichtempfindliche Zusammensetzung weitere Zusätze enthalten, wie z.B. Füllstoffe, Farbstoffe, Antioxidantien, Ozonschutzmittel und Plastifizierungsmittel. Bevorzugt werden 0 - 30 % an Plastifizierungsmittel z.B. auf der Basis von Polystyrol bzw. Polybutadien und mit einem mittleren Molekulargewicht zwischen 1 000 und 10 000 verwendet.

Die erfindungsgemäße, lichtempfindliche Zusammensetzung enthält allgemein 60 - 94,5 % Blockcopolymerisat, 5 - 30 % Monomermischung und 0,5 - 5 % Initiator.

Als Trägermaterialien für die erfindungsgemäße, lichtempfindliche Zusammensetzung für photopolymerisierbare Aufzeichnungsmaterialien eignen sich z.B. Folien aus den verschiedensten filmbildenden synthetischen Polymeren, besonders Polyester und Polyester-Polyamid-Folien, welche gegegebenenfalls mit einer Haftschicht versehen sein können. Eine durchsichtige Deckschicht, z.B. aus Polystyrol oder Polyethylen, kann verwendet werden, um Verunreinigungen oder Beschädigungen der lichtempfindlichen Schicht zu verhindern. Weitere Deckschichten, z.B. solche zur Verbesserung der Druckqualität, können ebenfalls verwendet werden.

Das photopolymerisierbare Aufzeichnungsmaterial mit der lichtempfindlichen Zusammensetzung gemäß der Erfindung kann nach den in der DE-PS 22 15 090 beschriebenen Methoden verarbeitet, belichtet und entwickelt werden.

Der Fachmann konnte nicht ohne weiteres erwarten, daß das erfindungsgemäß hergestellte photopolymerisierbare Aufzeichnungsmaterial Druckformen mit verbesserter Flexibilität und geringeren Rückstellkräften liefert, so daß eine gute Haftsicherheit auf dem Druckzylinder während des Druckvorganges gewährleistet wird, ohne daß negative Einflüsse auf andere Eigenschaften, wie z.B. eine Verringerung der Photoempfindlichkeit oder der Stabilität der Druckoberfläche, auftreten.

Überraschend war, daß mit dem erfindungsgemäß eingesetzten harten und steifen Blockcopolymeren, wie z.B. thermoplastisch, elastomeren Polystyrol-Polybutadien-Polystyrol- bzw. Polystyrol-Polyisopren-Polystyrol-Blockcopolymeren, Druckformen mit hoher Flexibilität und geringer Rückstellkraft herstellbar sind und somit eine verbesserte Haftsicherheit auf Druckzylindern erreicht werden kann.

Dies war insofern besonders überraschend, da durch eine bloße Konzentrationsverringerung von Monomeren mit mehreren ethylenisch ungesättigten Gruppen in lichtempfindlichen Zusammensetzungen für photopolymerisierbaren Aufzeichnungsmaterialien die Härte von Druckformen zwar erniedrigt werden kann, gleichzeitig aber die Flexibilität nur geringfügig zunimmt und die Photoempfindlichkeit, was aber sehr unerwünscht ist, erheblich geschwächt wird. Durch den erfindungsgemäßen Ersatz eines bestimmten Teils der Monomere mit mehreren ethylenisch ungesättigten Gruppen durch Monomere mit nur einer solchen Gruppe, kann dagegen die Flexibilität von Druckformen wesentlich stärker und auch wesentlich gezielter erhöht werden, ohne aber gleichzeitig auch die Härte der Druckformen zu stark zu erniedrigen.

Dies ist ein erheblicher Vorteil der erfindungsgemäßen, lichtempfindlichen Zusammensetzung für photopolymerisierbare Aufzeichnungsmaterialien, da die Druckformen eine bestimmte Härte (gemessen als Shore A nicht unter 35) besitzen sollten, damit eine ausreichende Stabilität der Druckformoberfläche und so eine gleichbleibende Druckqualität gewährleistet sind. Vergleicht man z.B. Druckformen mit gleicher Härte, die einmal durch eine Konzentrationserniedrigung der Monomere mit mehreren ethylenisch ungesättigten Gruppen und zum anderen durch eine bestimmte,erfindungsgemäße Mischung von einfach und mehrfach ethylenisch ungesättigten Verbindungen in der lichtempfindlichen Zusammensetzung erreicht wird, so stellt man fest, daß solche, die nach der erfindungsgemäßen Methode hergestellt werden, eine viel größere Flexibilität aufweisen.

Überraschend war ferner, daß erfindungsgemäß, hergestellte photopolymerisierbare Aufzeichnungsmaterialien eine wesentlich höhere Photoempfindlichkeit zeigen.

Dabei bestand das Vorurteil, daß durch den Einsatz einfach ethylenisch ungesättigter Verbindungen eine Abnahme der Photoempfindlichkeit und eine Verschlechterung der physikalischen Eigenschaften der gehärteten Druckform, bedingt durch eine geringere Vernetzung, hervorgerufen würde.

Gegenüber bekannten Methoden zur Herstellung photopolymerer Druckformen mit verbesserter Flexibilität bietet das erfindungsgemäß hergestellte photopolymerisierbare Aufzeichnungsmaterial wesentliche Vorteile. Mit der erfindungsgemäßen Technologie können kommerziell erhältliche, steife Blockcopolymere eingesetzt werden und durch Auswahl eines Monomergemisches nach Gesichtspunkten der Block/Monomer-Verträglichkeit unter Berücksichtigung der Löslichkeitsparameter und Glasübergangstemperaturen der entsprechenden Homopolymere können Druckformen mit verbesserter Flexibilität und Haftsicherheit hergestellt werden. Dabei besitzten die erfindungsgemäß hergestellten photopolymerisierbaren Druckformen die gleiche Photoempfindlichkeit und Härte wie herkömmliche dem Stand der Technik entsprechende.

Desweiteren kann die erfindungsgemäße, lichtempfindliche Zusammensetzung als Kantenabdeck- und/oder Spaltfüllmaterial für flexographische Druckplatten bzw. -formen verwendet werden. Für diesen Anwendungszweck wird lediglich das Verhältnis zwischen Bindemittel und Monomermischung auf 1:2 bis 1:4 verändert. Ein Zusatz von Mattierungsmitteln ist möglich. Mit diesem Material kann z.B. ein Spalt zwischen auf Druckzylinder montierten Druckplatten bzw. -formen flexibel verschlossen werden. Somit kann das Eindringen von Druckfarbenlösungsmittel verhindert und das hierdurch hervorgerufene Ablösen der Druckformen während des Druckprozesses verhindert werden.

Die mit der erfindungsgemäßen, lichtempfindlichen Zusammensetzung für photopolymerisierbare Aufzeichnungsmaterialien hergestellten Druckplatten bzw. - formen sind demnach von erheblichem Nutzen für die Druckindustrie, da durch ihren Einsatz unerwünschte Maschinen- und Produktionsstillstände vermieden werden können.

Die Erfindung wird durch die folgenden Beispiele näher erläutert, ohne jedoch hierauf beschränkt zu sein.

Die in den Beispielen angegebenen Prozente und Teile beziehen sich, soweit nicht anders angegeben, auf das Gewicht.

Für die Monomere wurden die folgenden Abkürzungen verwendet: C2A für Ethylacrylat, C8A für Octylacrylat, C10A für Isodecylacrylat, C12A für Dodecyclacrylat, C14A für Tetradecylacrylat, C2(OC6)A für 2-Hexyloxyethylacrylat, C10MA für Isodecylmethacrylat, C4DA für 1,4- Butandioldiacrylat, C6DA für 1,6- Hexandioldiacrylat, C6DMA für 1,6-Hexandioldimethacrylat, C12DMA für 1,12-Dodecandioldimethacrylat und TMPTA für Trimethylolpropantriacrylat und DIPETA für Dipentaerythritolmonohydroxyacrylat.

Beispiel 1

11 Druckplatten (1 - 11 in Tab. 1) mit 80 % Polystyrol-Polyisopren-Polystyrol-Blockcopolymerisat (SIS, MG 200 000, 15 % Polystyrolanteil) als Bindemittel, 10 % Monomerenmischung, 2 % Initiator, 2 % Inhibitor und 6 % Polystyrolharz (MG 1 000 - 6 000) wurden analog dem in der Patentschrift DE 22 15 090 Beispiel 10 beschriebenen Verfahren und mit den dort angegebenen Initiatoren und Inhibitoren hergestellt. Es wurde eine 0,12 mm dicke Polyethylenterephthalatträgerfolie verwendet und die Gesamtdicke der Druckplatten betrug 3 mm. Die eingesetzten ethylenisch ungesättigten Verbindungen und ihre Verhältnisse zueinander sind in Tabelle 1 wiedergegeben.

Beispiel 2

7 Druckplatten mit 60 % Polystyrol-Polybutadien-Polystryrol-Blockcopolymerisat als Bindemittel (13 - 18 in Tab. 1: SBS, MG 100 000, 30 % Polystyrolanteil, 12 in Tab. 1: radiales SBS, MG 140 000, 30 % Polystyrolanteil 17 % Monomerenmischung, 1 % Initiator, 2 % Inhibitor und 20 % flüssiges Polybutadien (MG 3 000 - 6 000) wurden analog zu Beispiel 1 hergestellt. Art und Verhältnisse der Monomerenmischung sind auch in Tabelle 1 wiedergegeben.

Zur Ermittlung der Photoempfindlichkeit wurden die nach Beispiel 1 und 2 hergestellten Druckplatten 15 Minuten durch einen Stauferstufenkeil (21 Stufen, Dichtedifferenz 0,15) mit einer handelsüblichen UV-Lampe belichtet, wie in der DE-PS 22 15 090 Beispiel 10 beschrieben entwickelt und die Anzahl der voll ausgebildeten Stufen bestimmt.

Zur Bestimmung der Härte und der Flexibilität wurden die Druckplatten 15 Minuten mit einer handelsüblichen UV-Lampe vollständig belichtet und wie oben beschrieben entwickelt. Die Härte wurde als Shore A nach DIN 53.505 gemessen.

Zur Charakterisierung der Flexibilität wurden die belichteten und entwickelten Druckplatten in 20 cm lange und 10 cm breite Streifen geschnitten, an ihrer schmalen Seite mit 2 cm Auflagebreite auf eine Kante gelegt und der Neigungswinkel zwischen der gedachten Verlängerung der Auflagefläche und der Sekanten, festgelegt durch den Auflagepunkt und den Endpunkt der Platte, mit einem Winkelmesser bestimmt.

Wie man aus der Tabelle 1 ersehen kann, besitzen die erfindungsgemäßen Druckformen eine deutlich bessere Flexibilität bei gleichbleibender Photoempfindlichkeit und guter Härte als herkömmliche mit ausschließlich mehrere ethylenisch ungesättigte Gruppen enthaltenden Monomere. Zwar läßt sich die Flexibilität auch durch eine Konzentrationsverrlngerung dieser Monomere in einem kleinen Rahmen verbessern, allerdings nur verbunden mit einer Verringerung der Photoempfindlichkeit und der Härte (Platten 1 und 2 bzw. 13 und 14). Auch der alleinige Einsatz von Monomeren mit nur einer ethylenisch ungesättigten Gruppe liefert kein befriedigendes Ergebnis (Platte 3), da in diesem Fall die Photoempfindlichkeit zu gering ist.

Es war deshalb nicht zu erwarten, daß bei stark reduziertem Gehalt an Monomeren mit mehreren ethylenisch ungesättigten Gruppen eine hohe Flexibilität bei gleichzeitiger ausreichender Photoempfindlichkeit und Härte zu erzielen ist.

Die mit den Druckplatten 7 und 11 erzielten Ergebnisse belegen, daß ein zu hoher Gehalt dieser Monomere, außerhalb des erfindungsgemäßen Bereichs des M1/M2-Verhältnisses von > 3:1 bis 10:1, zu steife Druckformen ergibt.

Beispiel 3

Zwei nach Beispiel 2 hergestellte Druckplatten wurden wie in der DE-PS 36 00 774 beschrieben belichtet, entwickelt, mit korrespondierenden Schrägschnitten versehen und der an diesen schrägen Stoßkanten auftretende Spalt mit der erfindungsgemäßen lichtempfindlichen Zusammensetzung wie in der DE-PS 36 00 774 beschrieben verschlossen.

Zusammensetzung:  30 % SDS (MG 120 000, 30 % Styrolanteil)
50 % C10A
10 % C6DA
5 % Initiator (vgl. DE-PS 22 15 090)
2 % Inhibitor (vgl. DE-PS 22 15 090)
3 % Reisstärke

Zur Charakterisierung der Stabilität des mit der erfindungsgemäßen lichtempfindlichen Zusammensetzung verschlossenen Spaltes wurde dieser in einen Wisch- bzw. Reibetest 5 Minuten mit einem Gemisch aus 80 Vol % Isopropanol und 20 % Vol % Ethylacetat behandelt. Das Material im Spaltbereich zeigte hierbei die gleiche Beständigkeit gegenüber dem Lösungsmittelgemisch wie das übrige Druckformmaterial.

Tabelle 1

| Platte | Bindemittel | Monomer 1 M1 | Monomer M2 | M1:M2 | Photoempfindlichkeit Stufen | Härte Shore A | Biegewinkel Grad |
|---|---|---|---|---|---|---|---|
| 1 | SIS | --- | C6DA | --- | 14 | 64 | 8 |
| 2 | SIS | --- | 1/2 C6DA | --- | 9 | 48 | 12 |
| 3 | SIS | C10A | --- | --- | 8 | 39 | 41 |
| 4 | SIS | C14A | C4DA | 6 : 1 | 13 | 43 | 36 |
| 5 | SIS | C8A | C12DMA | 8 : 1 | 13 | 43 | 41 |
| 6 | SIS | C6A | C6DMA | 1 : 1 | 13 | 49 | 27 |
| 7 | SIS | C10A | C6DA | 4 : 1 | 12 | 45 | 35 |
| 8 | SIS | C10MA | C6DA | 10 : 1 | 10 | 40 | 44 |
| 9 | SIS | C10A | C6DMA | 1 : 6 | 13 | 53 | 11 |
| 10 | SIS | C10A | C6DMA/TMPTA | 4:1:0,5 | 12 | 46 | 32 |
| 11 | SIS | C10A | C6DMA/DIPETA | 5:1:0,1 | 12 | 43 | 35 |
| 12 | rSBS | C10A | C4DA | 4 : 1 | 14 | 53 | 32 |
| 13 | SBS | --- | C6DA | --- | 13 | 72 | 2 |
| 14 | SBS | --- | 1/2 C6DA | --- | 7 | 59 | 13 |
| 15 | SBS | C10A | C6DA | 4 : 1 | 13 | 54 | 29 |
| 16 | SBS | C2(OC6)A | C6DA | 8 : 1 | 13 | 48 | 29 |
| 17 | SBS | C8A | C6DMA | 4 : 1 | 11 | 52 | 33 |
| 18 | SBS | C14A | C6DA | 5 : 1 | 10 | 49 | 35 |

**Patentansprüche**

1.  Lichtempfindliche Zusammensetzung für photopolymerisierbare Aufzeichnungsmaterialien, enthaltend
    a) mindestens ein thermoplastisch, elastomeres Blockcopolymerisat als Bindemittel,

EP 0 322 585 B1

b) mindestens zwei additionspolymerisierbare endständig ethylenisch ungesättigte Verbindungen und

c) einen Photoinitiator oder ein Photoinitiatorsystem, dadurch gekennzeichnet, daß

I) mindestens eine der additionspolymerisierbaren Verbindungen eine Verbindung mit nur einer Acrylat- bzw. Methacrylatgruppe ist und für ihre Homopolymere die Löslichkeitsparameter zwischen 7,6 und 9,6 und die Glasübergangstemperaturen unter 0° C liegen und

II) mindestens eine der additionspolymerisierbaren Verbindungen eine Verbindung mit mehreren Acrylat- bzw. Methacrylatgruppen ist und für ihre Homopolymere die Löslichkeitsparameter zwischen 9,6 und 12 liegen und

III) die Verbindungen mit nur einer und die Verbindungen mit mehreren Acrylat- bzw. Methacrylatgruppen in einem Verhältnis von > 3:1 bis 10:1 vorliegen.

2. Lichtempfindliche Zusammensetzung nach Anspruch 1 dadurch gekennzeichnet, daß die Verbindungen mit nur einer Acrylat- bzw. Methacrylatgruppe Ester offenkettiger, gegebenenfalls substituierter, aliphatischer Monoalkohole und/oder Monohydroxyether mit 2 bis 15 Kohlenstoffatomen in der Hauptkette sind.

3. Lichtempfindliche Zusammensetzung nach Anspruch 1 und 2 dadurch gekennzeichnet, die Verbindungen mit mehreren Acrylat- bzw. Methacrylatgruppen Ester alipatischer, gegebenenfalls substitutierter, Polyole und/oder Polyhydroxyether mit 2 bis 12 Kohlenstoffatomen in der Hauptkette sind.

4. Lichtempfindliche Zusammensetzung nach Anspruch 1 bis 3 dadurch gekennzeichnet, daß als Bindemittel lineare, gegebenenfalls ölverstreckte, Polystyrol-Polybutadien-Polystyrol und/oder Polystyrol-Polyisopren-Polystyrol-Blockcopolymere und/oder radiale, gegebenenfalls ölverstreckte, (Polystyrol-Polybutadien)$_4$Si und/oder (Polystyrol-Polyisopren)$_4$Si-Blockcopolymere mit einem Molekulargewicht von 80 000 - 300 000 und einem Polystyrolanteil von 10 - 40 % verwendet werden.

5. Photopolymerisierbares Aufzeichnungsmaterial, bestehend aus einem permanenten oder temporären Schichtträger, einer photopolymerisierbaren Schicht und gegebenenfalls einer oder mehreren Deckschichten, dadurch gekennzeichnet, daß die photopolymerisierbare Schicht eine lichtempfindliche Zusammensetzung nach Anspruch 1 bis 4 enthält.

6. Verwendung des in Anspruch 5 genannten photopolymerisierbaren Aufzeichnungmaterials zur Herstellung von Druckplatten bzw. -formen für den Flexodruck.

7. Verwendung der in den Ansprüchen 1 bis 4 genannten lichtempfindlichen Zusammensetzung als Kantenabdeck- und/oder Spaltfüllmaterial, dadurch gekennzeichnet, daß ein Verhältnis von Bindemittel zu Monomermischung von 1:2 bis 1:4 vorliegt.

**Claims**

1. Light sensitive composition for photopolymerizable recording elements comprising:

a) at least one thermoplastic-elastomer block copolymeric binder;

b) at least two addition-polymerizable compounds having terminal ethylenically unsaturated groups, and

c) a photoinitiator or photoinitiating system, characterized in that

(I) at least one of the addition-polymerizable compounds is a compound having only one acrylate or methacrylate group, said compound forms a homopolymer having a solubility parameter in the range between 7.6 and 9.6 and a glass transition temperature below 0 °C;

(II) at least one of the addition-polymerizable compounds is a compound having several acrylate or methacrylate groups, said compound forms a homopolymer having a solubility parameter in the range from 9.6 and 12; and

(III) the compounds having only one and the compounds having several acrylate or methacrylate groups are present in a ratio of > 3:1 to 10:1.

8

2. Light sensitive composition according to claim 1
characterized in that
the compounds having only one acrylate or methacrylate group are esters of opon chained, optionally substituted aliphatic monoalcohols and/or monohydroxyethers having 2 to 15 carbon atoms in the main chain.

3. Light sensitive composition according to claim 1 or 2
characterized in that
the compounds having several acrylate or methacrylate groups are esters of optionally substituted aliphatic polyols and/or polyhydroxyethers having 2 to 12 carbon atoms in the main chain.

4. Light sensitive composition according to claim 1 to 3
characterized in that
linear, optionally oil-extended polystyrene-polybutadiene-polystyrene and/or polystyrene-polyisoprene-polystyrene block copolymers and/or radial, optionally oil-extended (polystyrene-polybutadiene)$_4$ Si and/or (polystyrene-polyisoprene)$_4$ Si block copolymers having a molecular weight of 80 000 to 300 000 and a polystyrene share of 10 - 40% are used as binders.

5. Photopolymerizable recording element which comprises a permanent or temporary support, a photopolymerizable layer and optionally one or more cover layers
characterized in that
the photopolymerizable layer comprises a light sensitive composition according to claim 1 to 4.

6. Application of a photopolymerizable recording element according to claim 5 for making a flexographic printing plate or printing relief.

7. Application of a light sensitive composition according to claim 1 to 4 as a edge-sealing and/or gap-filling material,
characterized in that
the ratio of binder to monomer mixture is 1:2 to 1:4.

**Revendications**

1. Composition photosensible pour des matériaux d'enregistrement photopolmérisables, qui contient:
    a) au moins un copolymère séquencé élastomère et thermoplastique, en tant que liant,
    b) au moins deux composés à insaturation éthylénique en position terminale, polymérisables par addition, et
    c) un photo-initiateur ou un système photo-initiateur,
caractérisée en ce que:
    I) au moins l'un des composés polymérisables par addition est un composé présentant un groupe acrylate ou méthacrylate, et les paramètres de solubilité pour l'homopolymère étant compris entre 7,6 et 9,6 et les températures de transition vitreuse étant situées en-dessous de 0°C; et
    II) au moins l'un des composés polymérisables par addition est un composé à plusieurs groupes acrylates ou méthacrylates, et pour l'homopolymère, les paramètres de solubilité sont compris entre 9,6 et 12; et
    III) les composés avec un groupe acrylate ou méthacrylate et les composés avec plusieurs groupes acrylates ou méthacrylates sont présents selon un rapport compris entre > 3/1 à 10/1

2. Composition photosensible selon la revendication 1, caractérisée en ce que les composés présentant un groupe acrylate ou méthacrylate sont des esters de mono-alcools et/ou de monohydroxyéthers aliphatiques à chaîne ouverte, le cas échéant substitués, présentant de 2 à 15 atomes de carbone dans la chaîne principale.

3. Composition photosensible selon la revendication 1 ou 2, caractérisée en ce que les composés présentant plusieurs groupes acrylates ou méthacrylates sont des esters de polyol et/ou de polyhydroxyéthers aliphatiques, le cas échéant substitués, présentant de 2 à 12 atomes de carbone dans la chaîne principale.

**4.** Composition photosensible selon la revendication 1 à 3, caractérisée en ce que l'on utilise comme liant des copolymères séquencés polystyrène-polybutadiène-polystyrène et/ou polystyrène/polyisoprène/polystyrène linéaires, le cas échéant étirés à l'huile et/ou des copolymères séquencés (polystyrène-polybutadiène)₄ Si et/ou (polystyrène-polyisoprène)₄ Si radiaux, éventuellement étirés à l'huile, présentant un poids moléculaire de 800 00 à 300 000 et une proportion de polystyrène de 10 à 40%.

**5.** Matériau d'enregistrement photopolymérisable composé d'un support en couche permanent ou temporaire, d'une couche photopolymérisable et, le cas échéant, d'une ou de plusieurs couches de couverture, caractérisé en ce que la couche photopolymérisable contient une composition photosensible selon la revendication 1 à 4.

**6.** Application du matériau d'enregistrement photopolymérisable selon la revendication 5, pour la fabrication de plaques ou de formes d'impression pour l'impression flexographique.

**7.** Application de la composition photosensible selon les revendications 1 à 4, comme matériau de recouvrement d'arrêt et/ou de remplissage d'intervalles, caractérisée en ce que le rapport entre le liant et le mélange de monomères est compris entre 1/2 à 1/4.